# FASCICULE DE BREVET EUROPEEN

(11) **EP 3 430 478 B1**
(45) Date de publication et mention de la délivrance du brevet: **08.07.2020**
(21) Numéro de dépôt: 17710283.7
(22) Date de dépôt: 13.03.2017
(51) Int. Cl.: G04B 1/22, G04B 15/02, G04B 15/06, G04B 15/14, G04B 17/04, G04B 17/26, B81B 5/00

(54) **MÉCANISME POUR PIÈCE D'HORLOGERIE ET PIÈCE D'HORLOGERIE COMPRENANT UN TEL MÉCANISME**
MECHANISMUS FÜR EINE UHR UND UHR MIT SOLCH EINEM MECHANISMUS
MECHANISM FOR A TIMEPIECE AND TIMEPIECE COMPRISING SUCH A MECHANISM

(30) Priorité: 14.03.2016 FR 1652136
(43) Date de publication de la demande: 23.01.2019
(73) Titulaire: LVMH Swiss Manufactures SA, 2300 La Chaux-de-Fonds (CH)
(72) Inventeur: SEMON, Guy, 90350 Evette-Salbert (FR); MERCIER, Thomas, 2300 La Chaux-De-Fonds (CH); N'GUYEN, Thuy-Anh, 2300 La Chaux-De-Fonds (CH); LUSTIG, Maarten Pieter, 2611 EG Delft (NL)
(74) Mandataire: Plasseraud IP
(86) Numéro de dépôt international: PCT/EP2017/055872
(87) Numéro de publication internationale: WO 2017/157868

(56) Documents cités:
- EP-A1- 1 736 838
- EP-A1- 2 090 941
- EP-A1- 2 706 416
- EP-A1- 2 947 522
- CH-A- 442 153
- US-A- 1 522 099
- US-A- 2 481 213
- US-A- 3 440 815
- US-A- 5 535 178

## Description

### DOMAINE DE L'INVENTION

La présente invention est relative aux mécanismes pour pièces d'horlogerie et aux pièces d'horlogerie comprenant un tel mécanisme.

### ARRIERE PLAN DE L'INVENTION

On connaît des mécanismes pour pièce d'horlogerie comprenant :
- un régulateur comprenant un organe réglant adapté pour osciller avec une certaine amplitude nominale et une certaine période d'oscillation,
- un organe de distribution d'énergie pourvu de dents et destiné à être sollicité par un dispositif de stockage d'énergie,
- une ancre coopérant avec les dents de l'organe de distribution d'énergie, ladite ancre étant commandée par le régulateur pour régulièrement et alternativement bloquer et libérer l'organe de distribution d'énergie, de sorte que ledit organe de distribution d'énergie se déplace pas à pas sous la sollicitation du dispositif de stockage d'énergie selon un cycle de mouvement répétitif, et ladite ancre étant adaptée pour transférer de l'énergie mécanique au régulateur au cours de ce cycle de mouvement répétitif.

Les documents EP 1 736 838 A1 et EP 2 090 941 A1 présentent de tels mécanismes pour pièce d'horlogerie. L'amplitude nominale d'oscillation de l'organe réglant est l'amplitude d'oscillation dans les conditions normales de fonctionnement, quand le dispositif de stockage d'énergie est normalement chargé en énergie.

Ces mécanismes connus de ce type présentent notamment l'inconvénient que, lorsque le dispositif de stockage d'énergie n'a plus assez d'énergie, l'amplitude d'oscillation du régulateur diminue, ce qui modifie sa fréquence et perturbe la précision temporelle du mécanisme.

### OBJETS ET RESUME DE L'INVENTION

La présente invention a notamment pour objet de pallier cet inconvénient.

A cet effet, selon l'invention, un mécanisme du genre en question est caractérisé en ce qu'il comporte :
- un organe de découplage relié élastiquement, d'une part à l'ancre par des premiers moyens élastiques de liaison, et d'autre part à l'organe réglant par des deuxièmes moyens élastiques de liaison, ledit organe de découplage étant agencé pour osciller avec une certaine amplitude entre des première et deuxième positions extrêmes et avec la même période d'oscillation que l'organe réglant,
- des moyens de limitation de mouvement pour imposer lesdites positions extrêmes (ces positions extrêmes sont avantageusement fixes par rapport au cadre ou bâti sur lequel l'organe réglant est monté oscillant).

En d'autres termes, l'amplitude d'oscillation de l'organe de découplage, imposée par les moyens de limitation, est plus faible que l'amplitude d'oscillation qu'aurait ce même organe de découplage en l'absence des moyens de limitation. Les deux positions extrêmes de l'organe de découplage sont contraintes géométriquement par ces moyens de limitation.

Grâce à ces dispositions, l'amplitude d'oscillation de l'organe de découplage reste constante même si l'énergie stockée dans le dispositif de stockage d'énergie diminue sensiblement, de sorte que l'oscillateur continue à fonctionner normalement ; dans ces conditions, la précision temporelle du mécanisme est donc conservée.

Dans divers modes de réalisation du mécanisme selon l'invention, on peut éventuellement avoir recours en outre à l'une et/ou à l'autre des dispositions suivantes :
- les moyens de limitation de mouvement comprennent deux butées entre lesquelles oscille l'organe de découplage ;
- l'ancre et l'organe de distribution d'énergie sont conformés pour que, chaque fois que l'organe de distribution d'énergie se déplace, ledit organe de distribution d'énergie donne une impulsion à l'ancre pour transférer de l'énergie mécanique aux premiers moyens élastiques de liaison juste avant d'être bloqué à nouveau par l'ancre : ce blocage en fin d'impulsion implique que la position de l'ancre est fixée en fin d'impulsion, ce qui contribue à déterminer de façon précise et constante la quantité d'énergie transmise aux premiers moyens élastiques (cette quantité d'énergie est déterminée par la déformation des premiers moyens élastiques) ;
- l'ancre est montée sur une suspension élastique ;
- l'ancre et les premiers moyens élastiques de liaison sont conçus pour que l'ancre ne libère l'organe de distribution d'énergie que lorsque l'organe de découplage est au voisinage immédiat d'une des première et deuxième positions extrêmes (incluant le cas où l'organe de découplage est dans une des première et deuxième positions extrêmes) : on évite ainsi de perturber le régulateur avec l'échappement de l'ancre ;
- l'organe de distribution d'énergie est une roue d'échappement et l'ancre comporte des premier et deuxième organes d'arrêt disposés de part et d'autre de la roue d'échappement selon une direction d'échappement, les premier et deuxième organes d'arrêt étant adaptés pour alternativement bloquer des dents de la roue d'échappement, l'ancre étant montée et conformée pour occuper des première et deuxième positions de repos respectivement lorsque les premier et deuxième organes d'arrêt bloquent des dents de la roue d'échappement, et pour osciller entre deux extrema d'oscillation situés de part et d'autre des deux positions de repos dans la direction d'échappement ;
- l'organe de découplage est mobile dans la direction d'échappement entre lesdites première et deuxième positions extrêmes, les premiers moyens élastiques de liaison étant conçus pour déplacer l'ancre dans un premier sens dans la direction d'échappement en écartant le premier organe d'arrêt de la roue d'échappement lorsque l'organe de découplage est au voisinage immédiat de la première position extrême, les premiers moyens élastiques de liaison étant conçus pour déplacer l'ancre dans un deuxième sens opposé au premier sens dans la direction d'échappement en écartant le deuxième organe d'arrêt de la roue d'échappement lorsque l'organe de découplage est au voisinage immédiat de la deuxième position extrême, la première position extrême étant décalée dans le premier sens par rapport à la deuxième position extrême ;
- l'ancre et la roue d'échappement sont conformées pour que, chaque fois que la roue d'échappement se déplace, ladite roue d'échappement donne une impulsion à l'ancre pour transférer de l'énergie mécanique aux premiers moyens élastiques de liaison juste avant d'être bloquée à nouveau par l'ancre ;
- la roue d'échappement est conçue pour tourner dans un unique sens de rotation et chaque dent de la roue d'échappement comporte un bord avant convexe, orienté dans le sens de rotation, qui est adapté pour agir par effet de came sur soit le premier organe d'arrêt, soit le deuxième organe d'arrêt, pour donner ladite impulsion à l'ancre, ledit bord avant convexe s'étendant, dans un sens angulaire opposé à la direction de rotation, jusqu'à un bord d'arrêt adapté pour venir buter contre soit le premier organe d'arrêt, soit le deuxième organe d'arrêt, pour bloquer la roue d'échappement ;
- la roue d'échappement et l'ancre sont conçues pour qu'à la fin de chaque impulsion, les premiers moyens élastiques de liaison soient dans un état de déformation élastique imposé géométriquement, soit par la première position de repos de l'ancre et la deuxième position extrême de l'organe de découplage, soit par la deuxième position de repos de l'ancre et la première position extrême de l'organe de découplage : on garantit ainsi que l'on transfère vers le régulateur une énergie mécanique constante à chaque cycle ;
- l'amplitude de l'organe de découplage est inférieure à 25 % de l'amplitude nominale d'oscillation de l'organe réglant, notamment inférieure à 20 % de l'amplitude nominale d'oscillation de l'organe réglant ;
- l'amplitude de l'organe de découplage est supérieure à 5 % de l'amplitude nominale d'oscillation de l'organe réglant, notamment supérieure à 10 % de l'amplitude nominale d'oscillation de l'organe réglant ;
- les moyens de limitation de mouvement sont adaptés pour imposer à l'organe de découplage de rester immobile pendant un certain temps d'arrêt dans chacune des positions extrêmes, l'organe de découplage étant immobilisé lors de chaque période d'oscillation, pendant un certain temps d'arrêt total qui est supérieur à 75 % de la période d'oscillation, notamment supérieur à 80 % de la période d'oscillation ;
- le temps d'arrêt total est inférieur à 95 % de la période d'oscillation, notamment inférieur à 90 % de la période d'oscillation ;
- l'organe de découplage est rigide ;
- le régulateur, l'ancre et l'organe de découplage constituent un système monolithique formé dans une même plaque et sont conçus pour se déplacer essentiellement dans un plan moyen de ladite plaque ;
- l'organe de découplage est guidé par une suspension élastique qui relie ledit organe de découplage à un support fixe.

Par ailleurs, l'invention concerne également une pièce d'horlogerie comprenant un mécanisme tel que défini ci-dessus.

### BREVE DESCRIPTION DES DESSINS

D'autres caractéristiques et avantages de l'invention apparaîtront au cours de la description suivante d'un de ses modes de réalisation, donné à titre d'exemple non limitatif, en regard des dessins joints.

Sur les dessins :
- la figure 1 est une vue schématique d'une pièce d'horlogerie pouvant comprendre un mécanisme selon un exemple de réalisation de l'invention,
- la figure 2 est un schéma bloc du mouvement de la pièce d'horlogerie de la figure 1,
- la figure 3 est une vue en plan d'une partie du mouvement de la figure 2, comprenant le régulateur, l'organe de découplage, l'ancre, et l'organe de distribution d'énergie, selon une première forme de réalisation de l'invention,
- la figure 3A est une vue de détail agrandie montrant l'organe de distribution d'énergie et une partie de l'ancre,
- les figures 4 à 8 sont des vues similaires à la figure 3, montrant différentes positions successives du mécanisme,
- la figure 9 est une vue de détail similaire à la figure 3A, dans une variante de la première forme de réalisation de l'invention,
- la figure 10 est une vue similaire à la figure 3, dans une deuxième forme de réalisation de l'invention,
- et les figures 11 et 12 sont des vues similaires à la figure 10, montrant deux positions extrêmes du régulateur.

### DESCRIPTION PLUS DETAILLEE

Sur les différentes figures, les mêmes références désignent des éléments identiques ou similaires.

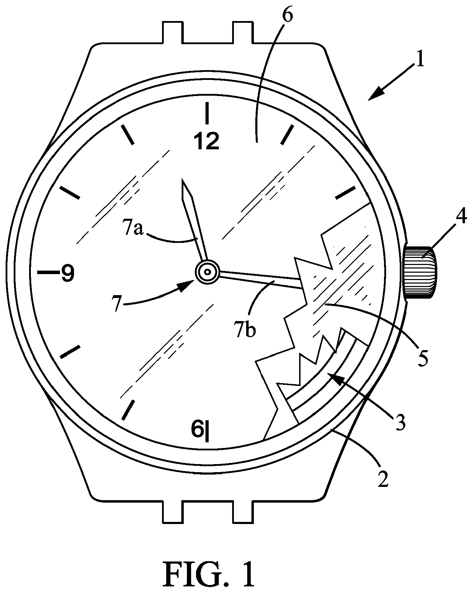

La figure 1 représente une pièce d'horlogerie 1 telle qu'une montre, comprenant :
- un boîtier 2,
- un mouvement horloger 3 contenu dans le boîtier 2,
- généralement, un remontoir 4,
- un cadran 5,
- un verre 6 recouvrant le cadran 5,
- un indicateur de temps 7, comprenant par exemple deux aiguilles 7a, 7b respectivement pour les heures et les minutes, disposé entre le verre 6 et le cadran 5 et actionné par le mouvement horloger 3.

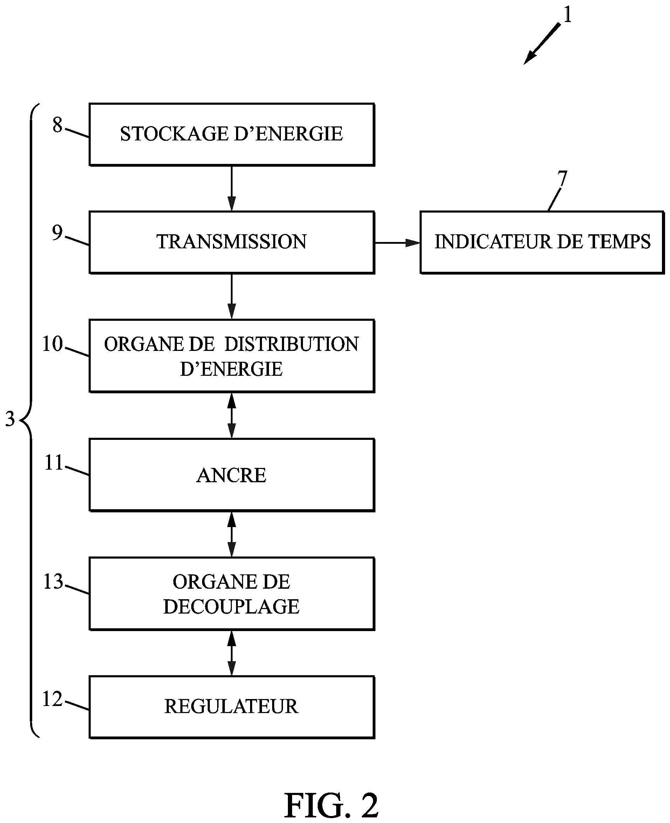

Comme représenté schématiquement sur la figure 2, le mouvement horloger 3 peut comprendre par exemple :
- un dispositif 8 de stockage d'énergie mécanique, généralement un ressort de barillet,
- une transmission mécanique 9 mue par le dispositif 8 de stockage d'énergie mécanique,
- l'indicateur de temps 7 susmentionné,
- un organe de distribution d'énergie 10 (par exemple une roue d'échappement),
- une ancre 11 adaptée pour séquentiellement retenir et libérer l'organe de distribution d'énergie 10,
- un régulateur 12, qui est un mécanisme comportant un organe réglant oscillant contrôlant l'ancre 11 pour la déplacer régulièrement de façon que l'organe de de distribution d'énergie soit déplacé pas à pas à intervalles de temps constants,
- et un organe de découplage 13 qui est interposé entre le régulateur 12 et l'ancre 11.

L'organe de découplage 13 est relié élastiquement d'une part, à l'ancre 11 par des premiers moyens élastiques de liaison R1 (premier ressort - non représenté sur les figures 1 et 2), et d'autre part, à l'organe réglant par des deuxièmes moyens élastiques de liaison R2 (deuxième ressort - non représenté sur les figures 1 et 2). Cet organe de découplage 13 est agencé pour osciller entre deux positions extrêmes avec la même période d'oscillation que l'organe réglant mais avec une amplitude moindre, qui est imposée par des moyens de limitation de mouvement (avantageusement, deux butées entre lesquelles oscille l'organe de découplage et qui limitent la course de l'organe de découplage pour lui imposer de rester immobile sur une partie de la période d'oscillation).

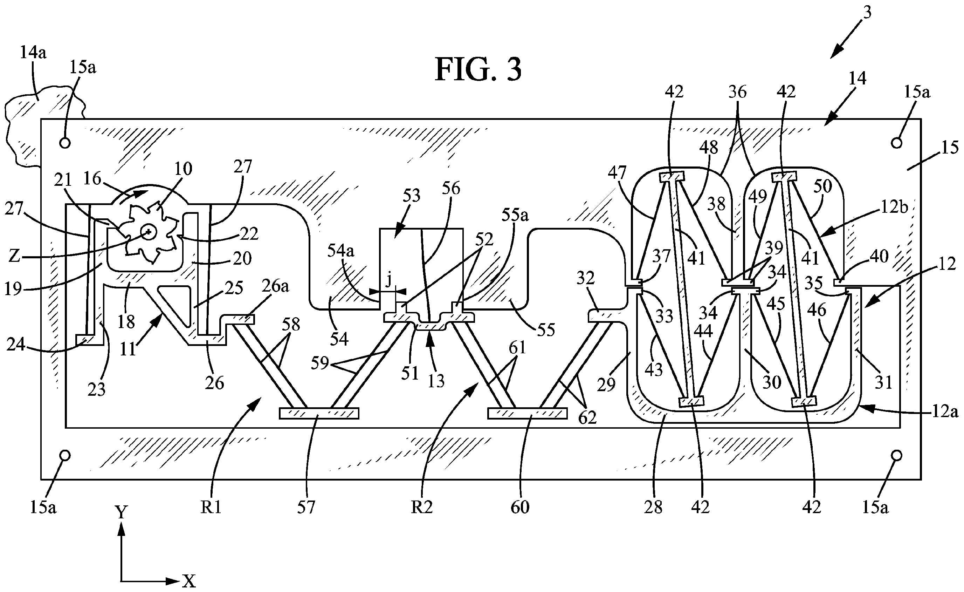

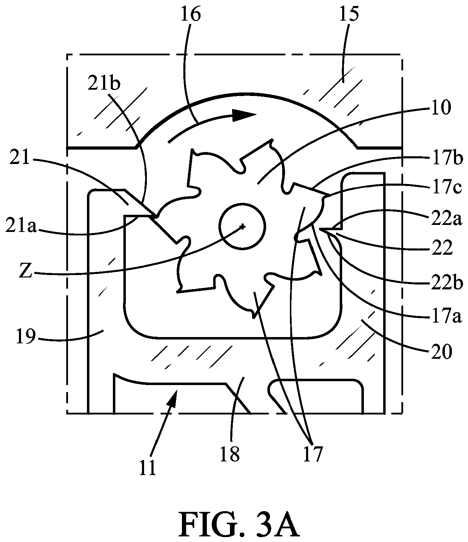

Le mouvement horloger 3 va maintenant être expliqué plus en détail à l'aide des figures 3 et 3A, qui représentent une première forme de réalisation où le régulateur 12, l'ancre 11 et l'organe de découplage 13 constituent un système monolithique formé dans une même plaque 14 (habituellement plane) et sont conçus pour se déplacer essentiellement dans un plan moyen de ladite plaque 14. L'invention n'est toutefois pas limitée à un tel système monolithique, l'organe de découplage 13 susmentionné pouvant être prévu dans tout mouvement horloger.

Dans l'exemple des figures 3 et 3A, la plaque 14 peut être de faible épaisseur, par exemple environ 0,1 à environ 0,6 mm, selon la nature du matériau de la plaque 14.

La plaque 14 peut avoir des dimensions transversales, dans le plan XY de la plaque (notamment largeur et longueur, ou diamètre), comprises entre environ 15 mm et 40 mm. X et Y sont deux axes perpendiculaires définissant le plan de la plaque 14.

La plaque 14 peut être fabriquée en tout matériau rigide adapté, ayant de préférence un module d'Young faible pour présenter de bonnes propriétés d'élasticité et une fréquence d'oscillation basse. Des exemples de matériaux utilisables pour réaliser la plaque 14 incluent le silicium, le nickel, l'alliage fer/nickel, l'acier, le titane. Dans le cas du silicium, l'épaisseur de la plaque 14 peut par exemple être comprise entre 0,2 et 0,6 mm.

Les différents organes formés dans la plaque 14, sont obtenus par réalisation d'ouvertures dans la plaque 14, obtenues par tout procédé de fabrication utilisé en micromécanique, en particulier les procédés utilisés pour la fabrication des MEMS.

Dans le cas d'une plaque 14 de silicium, la plaque peut être localement évidée par exemple par gravure ionique réactive profonde (DRIE - "Deep Reactive Ion Etching") ou éventuellement par découpe laser pour les petites séries.

Dans le cas d'une plaque 14 de fer/nickel, la plaque peut être notamment réalisée par le procédé LIGA, ou par découpe laser.

Dans le cas d'une plaque 14 d'acier ou de titane, la plaque 14 peut être évidée par exemple par électroérosion par fil (WEDM).

Les parties constitutives du mécanisme vont maintenant être décrites plus en détail. Certaines de ces parties sont rigides et d'autres sont élastiquement déformables, essentiellement en flexion. La différence entre les parties rigides et les parties élastiques, est leur raideur dans le plan XY de la plaque 14, qui est due à leur forme et en particulier à leur élancement. L'élancement peut être mesuré notamment par le rapport d'élancement (rapport longueur / largeur de la partie concernée). Par exemple, les parties rigides ont une raideur au moins environ 1000 fois plus élevée dans le plan XY, que les parties élastiques. Des dimensions typiques pour les liaisons élastiques, par exemple les branches élastiques 27, 43-50, 56, 58, 59, 61, 62 qui seront décrites ci-après, incluent des longueurs comprises par exemple entre 5 et 13 mm et des largeurs comprises par exemple entre 0,01 mm (10 µm) et 0,04 mm (40 µm), notamment environ 0,025 mm (25 µm).

La plaque 14 forme un cadre externe 15 fixe qui est fixé à une platine de support 14a, par exemple par des vis ou similaires (non représentées) traversant des trous 15a du cadre 15. La platine de support 14a est solidarisée au boîtier 2 de la pièce d'horlogerie 1. Le cadre 15 peut entourer au moins partiellement l'organe de distribution d'énergie 10, l'ancre 11, le régulateur 12 et l'organe de découplage 13.

L'organe de distribution d'énergie 10 peut être une roue d'échappement montée rotative par exemple sur la platine de support 14a, de façon à pouvoir tourner autour d'un axe de rotation Z perpendiculaire au plan XY de la plaque 14. L'organe de distribution d'énergie 10 est sollicité par le stockage d'énergie 8 dans un unique sens de rotation 16.

L'organe de distribution d'énergie 10 présente des dents externes 17, qui dans l'exemple représenté présentent un bord avant 17a (dans le sens de rotation 16) pouvant être par exemple convexe, un bord arrière 17b (à l'opposé du sens de rotation 16) pouvant être relativement droit, et un bec 17c faisant saillie à l'extrémité de la dent 17 et formant un bord d'arrêt. Le bec 17c peut former un rebord sensiblement radial par rapport à l'axe de rotation Z, orienté dans le sens de rotation 16.

L'ancre 11 est une pièce rigide qui peut comporter un corps rigide 18 s'étendant par exemple parallèlement à l'axe X et deux bras latéraux rigides parallèles 19, 20 s'étendant par exemple parallèlement à l'axe Y de part et d'autre de l'organe de distribution d'énergie 10. Les bras 19, 20 comportent respectivement deux organes d'arrêt 21, 22 en forme de doigts faisant saillie l'un vers l'autre dans la direction de l'axe X à partir des bras 19, 20. Avantageusement, chaque organe d'arrêt est en forme de biseau et comporte une face d'arrêt 21a, 22a disposée sensiblement radialement par rapport à l'axe de rotation Z et orientée dans le sens opposé au sens de rotation 16, et une face opposée 21b, 22b.

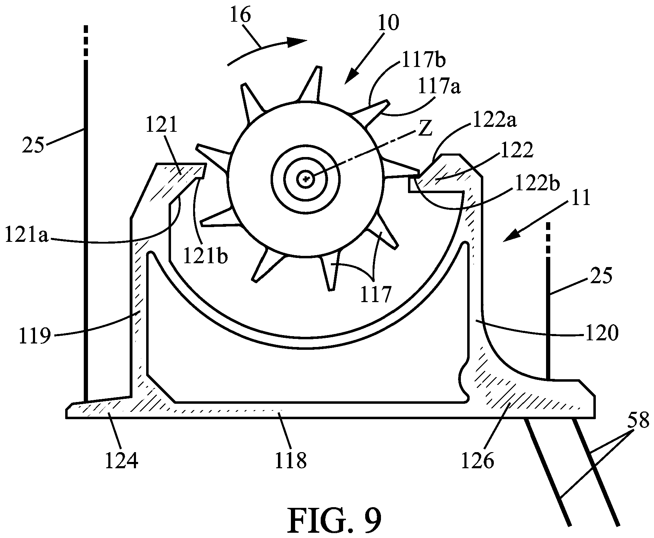

En variante, comme représenté sur la figure 9, les profils des dents 117 de la roue d'échappement 10 et des organes d'arrêt 121, 122 de l'ancre 11 peuvent être réalisés à l'inverse. Dans ce cas, les dents 117 de la roue peuvent avoir un profil simple sans bec, avec un bord avant 117a (dans le sens de rotation 16) pouvant être par exemple droit et radial par rapport à l'axe de rotation Z0, et un bord arrière 117b (à l'opposé du sens de rotation 16) pouvant être relativement droit et en biais par rapport à la direction radiale. L'ancre 11 peut être montée mobile par exemple de la même façon que sur la figure 3. L'ancre 11 est une pièce rigide qui peut comporter un corps rigide 118 s'étendant par exemple parallèlement à l'axe X et deux bras latéraux rigides parallèles 119, 120 s'étendant par exemple parallèlement à l'axe Y de part et d'autre de l'organe de distribution d'énergie 10. Les bras 119, 120 comportent respectivement les deux organes d'arrêt 121, 122 en forme de doigts faisant saillie l'un vers l'autre dans la direction de l'axe X à partir des bras 119, 120. Dans la variante de la figure 9, chaque organe d'arrêt 121, 122 peut comporter une rampe d'impulsion 121a, 122a contre laquelle glissent les sommets des dents 117 dans le sens de la flèche 16, chaque rampe d'impulsion 121a, 122a se terminant dans le sens de rotation 16 de la roue 10, par un bec d'arrêt 121b, 122b sensiblement radial par rapport à l'axe de rotation Z.

L'ancre 11 est reliée élastiquement au cadre 15, de façon à pouvoir se déplacer parallèlement à l'axe X, qui forme ainsi la direction d'échappement. Avantageusement, l'ancre 11 peut être reliée au cadre 15 par une suspension élastique, comprenant par exemple deux branches élastiques 27 sensiblement parallèles à l'axe Y. Eventuellement, les branches élastiques 27 peuvent être disposées de part et d'autre des bras latéraux 19, 20, et l'ancre 11 peut comporter deux jambages 23, 25 qui s'étendent selon l'axe Y à l'opposé des bras latéraux 19, 20, ces jambages étant terminés par des pattes 24, 26 s'étendant selon l'axe X. Les branches élastiques 27 peuvent éventuellement être reliées à ces pattes 24, 26. La patte 26 située vers le régulateur 12, peut éventuellement se prolonger vers ledit régulateur par une extension 26a dont l'utilité sera vue plus loin.

Le régulateur 12 est un oscillateur mécanique comportant un organe réglant 12a rigide, formant une masse inertielle, et une suspension élastique 12b qui relie l'organe réglant 12a au cadre 15. Cette suspension élastique permet à l'organe réglant d'osciller avec une période d'oscillation donnée et une amplitude nominale A0 donnée (non représentée). Dans l'exemple représenté, la suspension élastique 12b est adaptée pour que l'organe réglant 12a oscille sensiblement selon une translation rectiligne, parallèle à l'axe X, mais le régulateur 12 pourrait être de tout autre type, notamment rotatif.

Dans l'exemple considéré, l'organe réglant 12a peut comporter un corps 28 rigide s'étendant sensiblement selon l'axe X, et trois branches rigides parallèles 29 - 31 s'étendant selon l'axe Y à partir du corps 28, par exemple dans la même direction que les bras latéraux 19, 20 susmentionnés. La branche 29 la plus proche de l'ancre 11 peut comporter une patte externe 32 s'étendant selon l'axe X. Les branches 29, 30 peuvent comporter des pattes internes, respectivement 33, 34, s'étendant l'une vers l'autre selon l'axe X. Les branches 30, 31 peuvent également comporter des pattes internes, respectivement 34, 35, s'étendant l'une vers l'autre selon l'axe X.

Eventuellement, le cadre 15 peut comporter deux évidements 36, débouchant respectivement face aux espaces laissés libres entre les branches 29, 30, 31 de l'organe réglant 12a. Ces évidements 36 sont séparés par une branche rigide 38 s'étendant selon l'axe Y. L'évidement 36 le plus proche de l'ancre 11 peut comporter, au niveau de son débouché vers l'organe réglant 12a, des pattes 37, 39 s'étendant l'une vers l'autre selon l'axe X. L'évidement 36 le plus éloigné de l'ancre 11 peut comporter, au niveau de son débouché vers l'organe réglant 12a, des pattes 39, 40 s'étendant l'une vers l'autre selon l'axe X.

La suspension élastique 12b peut comporter deux biellettes rigides 41, s'étendant sensiblement selon l'axe Y, respectivement dans les évidements 36 et dans les espaces laissés libres entre les branches 29, 30, 31 de l'organe réglant 12a. Chacune de ces biellettes 41 peut comporter, à chacune de ses extrémités longitudinales, une tête élargie 42 s'étendant sensiblement selon l'axe X. Les têtes 42 des biellettes 41 peuvent être reliées par des branches élastiques 43-50, respectivement aux pattes susmentionnées 33-35 de l'organe réglant 12a et aux pattes 37, 39, 40 du cadre 15. D'autres types de suspension élastique 12b sont bien entendu possibles.

L'organe de découplage 13 peut être une pièce rigide, comportant par exemple un corps 51 rigide qui s'étend sensiblement selon l'axe X et deux contrebutées rigides 52 faisant saillie dans la direction de l'axe Y à l'intérieur d'un évidement 53 ménagé dans le cadre 15 du même côté que les évidements 36 susmentionnés, entre deux butées rigides 54, 55.

L'organe de découplage 13 est monté en suspension dans le cadre 15 par les moyens élastiques de liaison R1, R2 pour osciller sensiblement en translation selon l'axe X, de façon que les contrebutées 52 butent tour à tour contre les faces de butées en regard 54a, 55a des butées 54, 55, avec une distance totale de déplacement j, mais le mouvement de cet organe de découplage 13 pourrait être d'un autre type, notamment rotatif. L'amplitude j/2 d'oscillation de l'organe de découplage est inférieure à l'amplitude nominale A0 de l'organe réglant 12a.

Ce mouvement peut éventuellement être guidé en outre par au moins une branche élastique 56 qui s'étend dans l'évidement 53 sensiblement selon l'axe Y et qui relie l'organe de découplage 13 au cadre 15.

Avantageusement, A0 et j sont tels que l'amplitude j/2 est inférieure à 25 % de A0, notamment inférieure à 20 % de A0. L'amplitude j/2 peut être supérieure à 5 % de A0, notamment supérieure à 10 % de A0.

Ainsi, l'organe de découplage 13 reste immobile contre les butées 54, 55 pendant un temps d'arrêt total qui est supérieur à 75 % de la période d'oscillation T, notamment supérieur à 80 % de T. Le temps d'arrêt total peut être par ailleurs inférieur à 95 % de la période d'oscillation T, notamment inférieur à 90 % de T.

Les moyens élastiques de liaison R1, R2 peuvent être de tout type connu. Dans l'exemple considéré, les moyens élastiques de liaison R1 peuvent comporter des branches élastiques 58, 59 reliées entre elles par un élément intermédiaire rigide 57, s'étendant par exemple selon l'axe X. Les branches élastiques 58, 59 s'étendent en V ouvert vers le côté du cadre 15 qui comporte l'évidement 53, respectivement jusqu'à l'extension 26a de l'ancre 11 et jusqu'au corps 51 de l'organe de découplage 13. Les moyens élastiques de liaison R1 comportent deux branches élastiques parallèles 58 et deux branches élastiques parallèles 59 dans l'exemple représenté, mais pourraient éventuellement comporter une seule branche élastique 58 et / ou une seule branche élastique 59, ou des nombres différents de branches élastiques, selon la raideur élastique recherchée.

De même, les moyens élastiques de liaison R2 peuvent comporter des branches élastiques 61, 62 reliées entre elles par un élément intermédiaire rigide 60, s'étendant par exemple selon l'axe X. Les branches élastiques 61, 62 s'étendent en V ouvert vers le côté du cadre 15 qui comporte l'évidement 53, respectivement jusqu'au corps 51 de l'organe de découplage 13 et jusqu'à la patte externe 32 de l'organe réglant 12a. Les moyens élastiques de liaison R2 comportent deux branches élastiques parallèles 61 et deux branches élastiques parallèles 62 dans l'exemple représenté, mais pourraient éventuellement comporter une seule branche élastique 61 et / ou une seule branche élastique 62, ou des nombres différents de branches élastiques, selon la raideur élastique recherchée.

Le mécanisme précédemment décrit fonctionne comme suit. Dans ce qui suit, on utilise éventuellement les notions de haut / bas, droite / gauche pour clarifier la description au regard de l'orientation des dessins des figures 3 à 8, mais ces indications ne sont pas limitatives.

Dans la situation de la figure 3, l'ancre 11 est dans une première position de repos et l'organe de distribution d'énergie 10 est arrêté, le bec 17c de la dent 17 situé vers la gauche étant au contact de la face d'arrêt 21a de l'organe d'arrêt 21 situé sur la gauche de l'ancre 11.

L'organe de découplage 13 est dans sa position extrême de droite (en butée contre la butée de droite 55) ou proche de cette position, et l'organe réglant 12a est proche de sa position extrême vers la droite.

Les premiers moyens élastiques R1 présentent une élongation maximale fixée géométriquement par la position gauche de l'ancre 11 (première position de repos) et par la position droite de l'organe de découplage 13 (deuxième position extrême). L'énergie mécanique accumulée alors dans les premiers moyens élastiques R1 est donc prédéterminée, constante à chaque cycle.

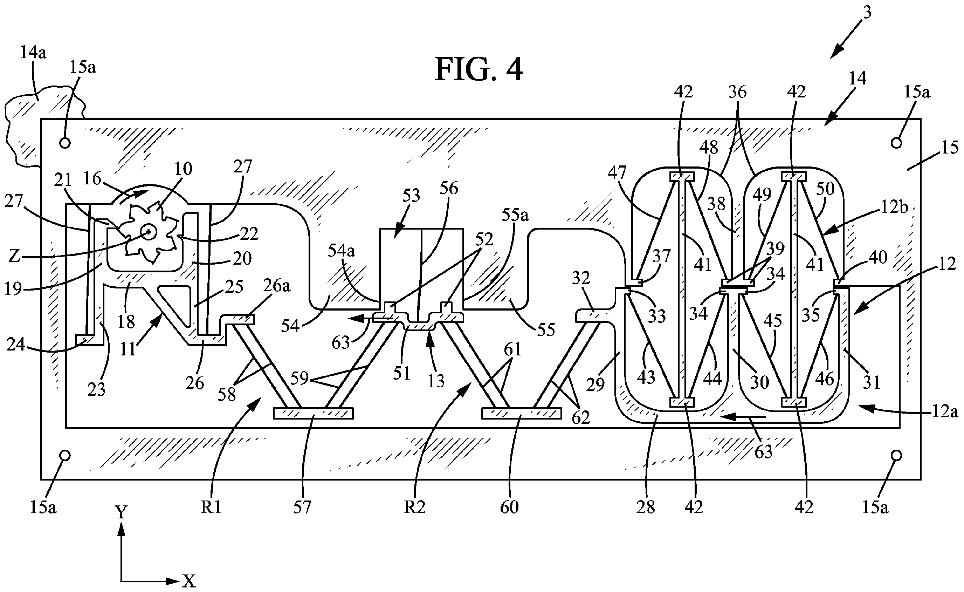

A partir de la position de la figure 3, comme représenté sur la figure 4, l'organe réglant 12a se déplace vers la gauche dans le sens de la flèche 63, et l'organe de découplage 13 se déplace aussi vers la gauche dans le sens de la flèche 63.

L'énergie précédemment accumulée dans les premiers moyens élastiques R1 est alors transmise au régulateur 12 pour entretenir son oscillation, en tirant l'organe réglant 12a vers la gauche.

Tant que les premiers moyens élastiques R1 sont en élongation, ils tirent l'ancre 11 vers la droite et la maintiennent donc dans sa première position de repos, en bloquant l'organe de distribution d'énergie 10 comme expliqué précédemment.

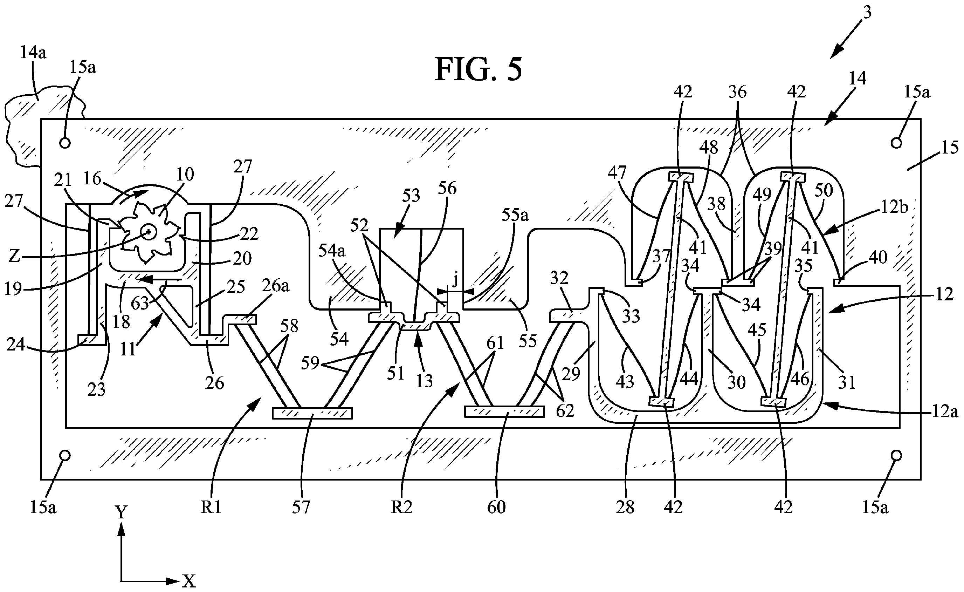

Lorsque l'organe de découplage 13 est proche d'atteindre sa position extrême de gauche ou deuxième position extrême (en butée contre la butée de gauche 54), comme représenté sur la figure 5, les premiers moyens élastiques R1 sont proches de leur longueur au repos et entrainent l'ancre 11 vers la gauche, ce qui a pour effet de lui faire quitter sa position premier de repos, provoquant ainsi l'échappement de l'organe de distribution d'énergie 10, qui peut ensuite tourner dans le sens de rotation 16.

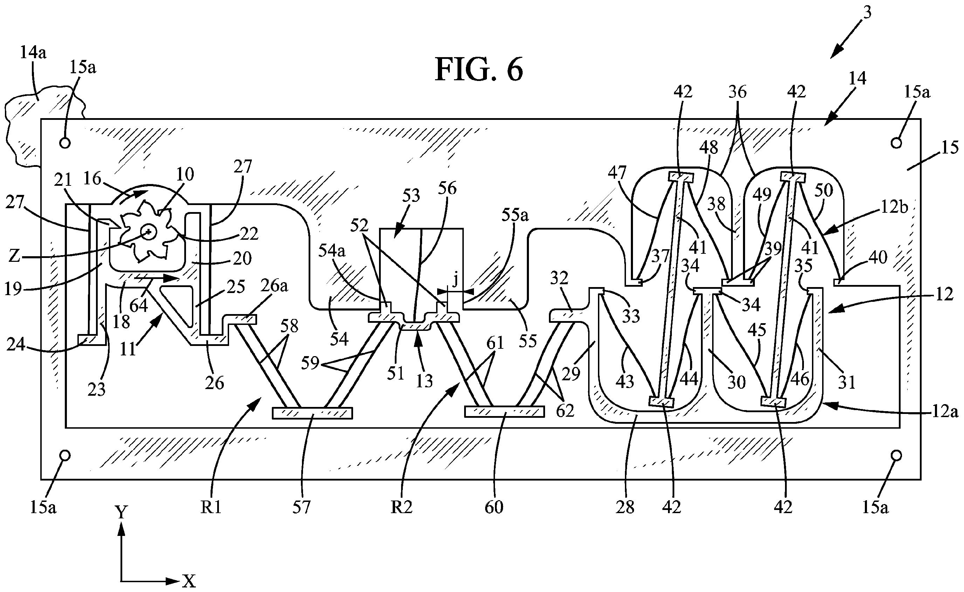

Du fait de l'échappement de l'organe de distribution d'énergie 10, le bord avant convexe 17a de la dent 17 situé vers la droite vient en contact avec l'organe d'arrêt 22 situé sur la droite de l'ancre 11, ce qui, par effet de came, provoque le déplacement de l'ancre 11 vers la droite dans le sens de la flèche 64 jusqu'à une deuxième position de repos où le bec 17c de la dent 17 située vers la droite vient en appui contre la face d'arrêt 22a de l'organe d'arrêt 22 (figure 6). Cette impulsion donnée par l'organe de distribution d'énergie 10 transfère de l'énergie aux premiers moyens élastiques R1, en les comprimant. Pendant ce mouvement, l'organe de découplage 13 reste dans sa position extrême de gauche (première position extrême), contre la butée 54 et l'organe réglant 12a est alors dans sa position extrême de gauche, ou proche de cette position.

Les premiers moyens élastiques R1 présentent alors une élongation minimale fixée géométriquement par la position droite de l'ancre 11 et par la position gauche de l'organe de découplage 13. Les premiers moyens élastiques R1 ont alors une énergie mécanique accumulée prédéterminée, constante à chaque cycle.

De plus, l'échappement et l'apport d'énergie dans les premiers moyens élastiques R1 se fait lorsque l'organe de découplage 13 est en butée, c'est-à-dire que l'organe réglant 12a est en oscillation quasi libre. Ainsi, l'oscillation de l'organe réglant 12a n'est pas perturbée par l'échappement de l'organe de distribution d'énergie 10 et l'impulsion qu'il donne à l'ancre 11.

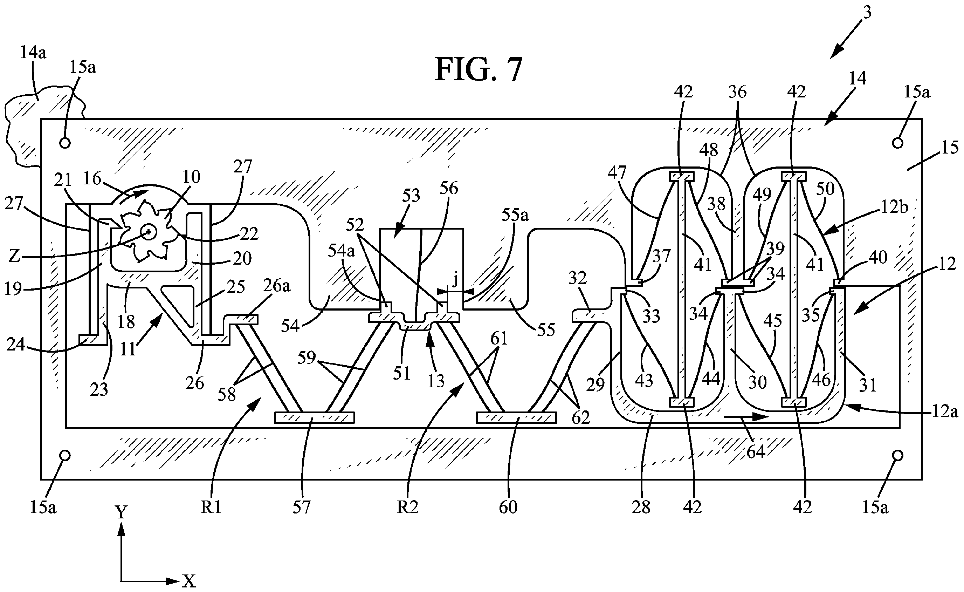

Comme représenté sur la figure 7, l'organe réglant 12a reprend ensuite son mouvement en se déplaçant vers la droite dans le sens de la flèche 64 et son oscillation est entretenue grâce à l'énergie accumulée dans les premiers moyens élastiques R1, qui est distribuée dans le système.

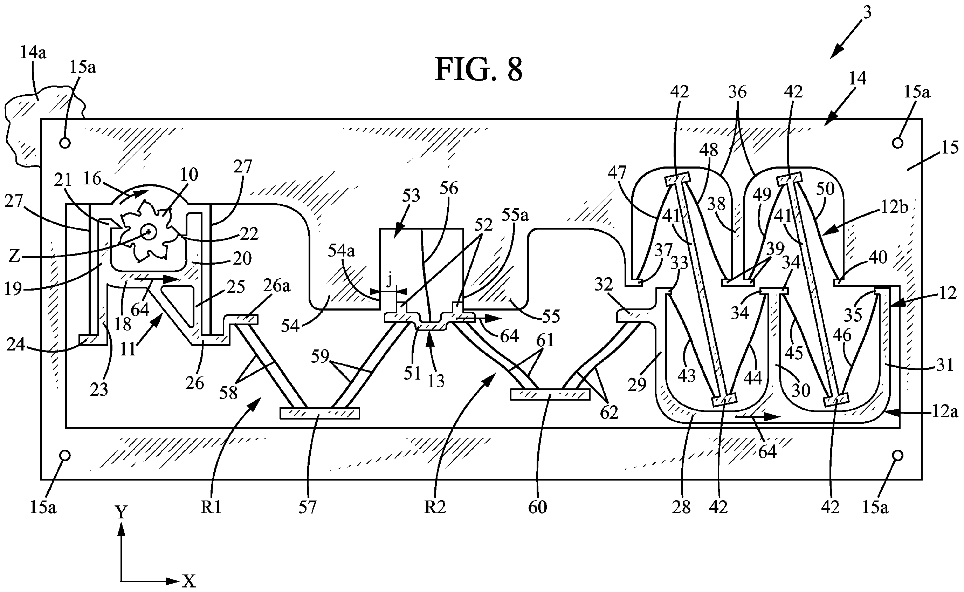

A la fin de ce mouvement, l'ancre 11 est tirée vers la droite dans le sens de la flèche 64 (figure 8), de sorte que l'organe de distribution d'énergie 10 échappe et tourne dans le sens de rotation 16. Par la suite, le bord avant convexe 17a de la dent 17 située vers la gauche coopère avec l'organe d'arrêt 21 de l'ancre par effet de came, pour déplacer l'ancre 11 vers la gauche, de façon à revenir à la situation de la figure 3.

Ces étapes se répètent ensuite indéfiniment.

Le dispositif qui vient d'être décrit présente notamment les avantages suivants :
- l'organe de découplage 13 et les ressorts R1, R2 rendent le fonctionnement de l'ancre 11 indépendant ou quasiment indépendant du régulateur, du fait que les impulsions de la roue d'échappement sont transmises à l'ancre quand l'organe de découplage 13 est en butée et que la libération de la roue d'échappement 10 a lieu quand l'organe de découplage 13 est au voisinage immédiat d'une de ses positions extrêmes (par exemple, course restante jusqu'à la position extrême inférieure à j/10): on évite ainsi de perturber le régulateur par les impulsions ou l'échappement ;
- l'apport d'énergie au régulateur 12 par la roue d'échappement à chaque phase d'impulsion, est déterminé par le chargement du ressort R1 en énergie, lequel chargement est entièrement déterminé par son état de déformation en fin d'impulsion de la roue d'échappement 10 : cet état de déformation est ici entièrement déterminé par la position extrême de l'organe de découplage 13et la position de repos correspondante de l'ancre 11, de sorte que ce transfert d'énergie est rigoureusement constant.

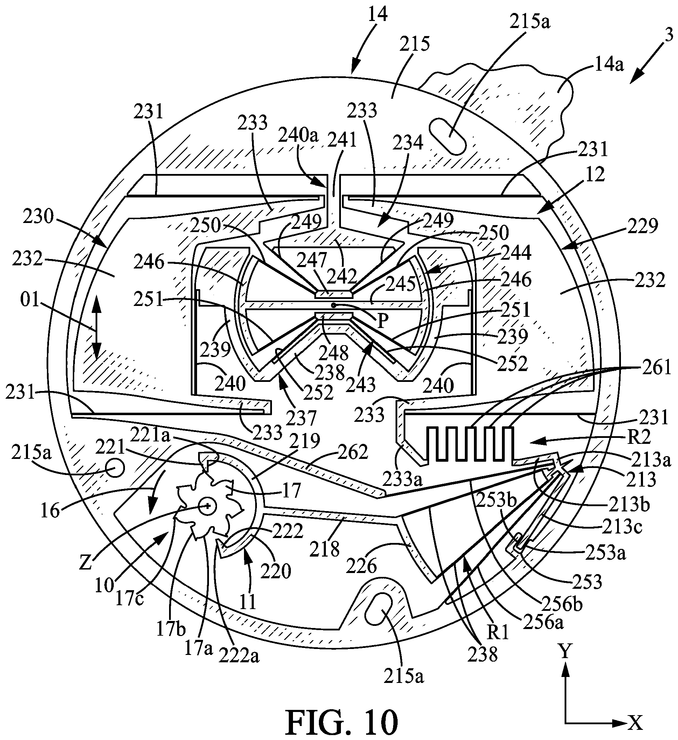

Dans la deuxième forme de réalisation de l'invention, représentée sur la figure 10, le régulateur 12, l'ancre 11 et l'organe de découplage 13 peuvent à nouveau constituer un système monolithique formé dans une même plaque 14 (habituellement plane), comme expliqué précédemment pour la première forme de réalisation de l'invention, et sont conçus pour se déplacer essentiellement dans un plan moyen de ladite plaque 14.

Comme décrit précédemment, la plaque 14 forme un cadre externe 215 fixe qui est fixé à une platine de support 14a, par exemple par des vis ou similaires (non représentées) traversant des trous 215a du cadre 215. La platine de support 14a est solidarisée au boîtier 2 de la pièce d'horlogerie 1. Le cadre 215 peut entourer au moins partiellement l'organe de distribution d'énergie 10, l'ancre 11 et le régulateur 12.

L'organe de distribution d'énergie 10 peut être une roue d'échappement identique ou similaire à celle décrite précédemment en regard des figures 3 et 3A.

L'ancre 11 est une pièce rigide qui peut comporter un corps rigide 218 s'étendant par exemple sensiblement radialement par rapport à l'axe de rotation Z de la roue d'échappement 1 et deux bras latéraux rigides parallèles 219, 220 s'étendant à partir du corps rigide 218 pour englober partiellement la roue d'échappement 10. Les bras 219, 220 comportent respectivement deux organes d'arrêt 221, 222 en forme de doigts faisant saillie l'un vers l'autre radialement par rapport à l'axe de rotation Z, à partir des bras 219, 220. Les organes d'arrêt 221, 222 peuvent être similaires à ceux des figures 3 et 3A, et peuvent comporter chacun une face d'arrêt 221a, 222a disposée sensiblement radialement par rapport à l'axe de rotation Z et adaptée pour coopérer par butée avec les becs 17c de la roue d'échappement.

L'ancre 11 est reliée élastiquement au cadre 215, de façon à pouvoir se déplacer en rotation autour d'un centre de rotation éloigné de la roue d'échappement 10 (non représenté et décrit plus loin), de façon que les organes d'arrêt 221, 222 se déplacent sensiblement radialement par rapport à l'axe de rotation Z de la roue d'échappement.

Avantageusement, l'ancre 11 peut être reliée au cadre 15 par une suspension élastique comprenant un organe de découplage 213 rigide qui sera décrit ci-après.

Le régulateur 12 est un oscillateur mécanique comportant des premier et deuxième organes réglants 229, 230 formant chacun une masse inertielle rigide, reliés chacun au cadre 215 par et une suspension élastique qui est adaptée pour que les premier et deuxième organes réglants 229, 230 oscillent selon l'axe Y, dans une direction de translation O1.

Les suspensions élastiques des premier et deuxième organes réglants 229, 230 peuvent comporter par exemple chacune deux branches élastiques 231 s'étendant sensiblement selon l'axe X et reliées au cadre 215.

Chacun des premier et deuxième organes réglants 229, 230 est donc monté sur le cadre 215 pour osciller en translation circulaire, avec une amplitude d'oscillation dans la direction de translation O1 et avec une amplitude d'oscillation secondaire, non-nulle, perpendiculairement à la direction de translation O1. Ladite amplitude d'oscillation dans la direction de translation O1 est supérieure à l'amplitude d'oscillation secondaire des premier et deuxième organes réglants, par exemple au moins 10 fois plus grande que l'amplitude d'oscillation secondaire.

Dans l'exemple représenté, les premier et deuxième organes réglants 229, 230 peuvent présenter chacun une forme de C, avec un corps principal 232 s'étendant selon l'axe Y entre deux bras latéraux 233 s'étendant vers l'intérieur du cadre 215. Les branches élastiques 231 susmentionnées peuvent avantageusement être reliées aux extrémités libres des bras latéraux 233, ce qui permet d'avoir des branches élastiques 231 longues et donc particulièrement souples.

Les premier et deuxième organes réglants 229, 230 peuvent être deux pièces symétriques, de masse identique ou sensiblement identique. Ils peuvent définir entre eux un espace central libre 234.

Dans l'espace intérieur libre 234 est disposé un levier d'équilibrage 237 rigide, monté pivotant autour d'un centre de rotation P central. Le levier d'équilibrage 237 peut éventuellement présenter une forme sensiblement en M, avec une partie centrale 238 en V divergeant à partir du centre de rotation P et deux bras latéraux 239.

Les bras latéraux 239 peuvent être reliés respectivement aux premier et deuxième organes réglants 229, 230, par exemple par deux branches élastiques 240 s'étendant sensiblement selon l'axe Y.

Le levier d'équilibrage 237 peut être monté, par une suspension élastique 243, sur un support rigide 240a rigidement relié au cadre 215. Le support rigide 240a peut par exemple comporter un bras 241 s'étendant selon l'axe Y entre les organes réglants 229, 230, depuis le cadre 15 jusqu'à une tête 242 qui peut par exemple s'étendre selon l'axe X en donnant au support 240a une forme en T.

La suspension élastique 243 peut par exemple comporter :
- un organe pivotant rigide 244 disposé à l'intérieur du levier d'équilibrage 237, comprenant par exemple une âme centrale 245 au niveau du centre de rotation P, s'étendant selon l'axe X entre deux têtes élargies 246,
- deux corps intermédiaires rigides 247, 248 disposés de part et d'autre de l'âme centrale 245 près du centre de rotation P,
- deux branches élastiques 249 reliant respectivement les extrémités libres de la tête 242 du support rigide 240a au corps intermédiaire rigide 247,
- deux branches élastiques 250 reliant respectivement le corps intermédiaire rigide 247 à l'une des extrémités libres des têtes élargies 246,
- deux branches élastiques 251 symétriques des branches élastiques 250, reliant respectivement le corps intermédiaire rigide 248 à l'autre des extrémités libres des têtes élargies 246,
- deux branches élastiques 252 reliant le corps intermédiaire rigide 248 respectivement aux extrémités de la partie centrale 238 du levier d'équilibrage.

Le levier d'équilibrage 237 impose aux premier et deuxième organes réglants 229, 230 de se déplacer de façon symétrique et opposée selon la direction de translation O1.

Ces mouvements opposés permettent un équilibrage dynamique du mécanisme, qui permet de diminuer la sensibilité du mécanisme aux chocs, à la gravité et plus généralement aux accélérations.

L'organe de découplage 213 peut comporter par exemple une base 213a rigide et deux bras rigides 213b, 213c divergeant en direction de la roue d'échappement 10, les directions des bras 213b, 213c se croisant par exemple sensiblement au niveau du centre de rotation susmentionné de l'ancre 11.

L'organe de découplage 213 peut être monté pivotant sur le cadre 215 autour du centre de rotation susmentionné de l'ancre 11, par exemple par deux branches élastiques 256a, 256b qui divergent à partir de la base 213a, entre les bras 213b, 213c de l'organe de découplage et sont reliées au cadre 215. La branche élastique 256a la plus éloignée du régulateur 12 peut par exemple être reliée directement au cadre 215, et l'autre branche élastique 256b, plus proche du régulateur 12, peut être reliée à un bras rigide 262 faisant saillie à l'intérieur du cadre 215 selon une direction faiblement inclinée par rapport à l'axe Y.

Le bras 262 peut éventuellement séparer partiellement la roue d'échappement 10 et l'ancre 11 du régulateur 12.

L'organe de découplage 213 peut être relié élastiquement à l'ancre 11, par exemple par deux branches élastiques 238 divergeant à partir de la base 213a à l'intérieur des branches élastiques 256a, 256b susmentionnées jusqu'à un bras rigide 226 solidaire du corps 218. Les directions des deux branches élastiques peuvent avantageusement se croiser sensiblement au niveau du centre de rotation susmentionné de l'ancre 11. Ces branches élastiques 238 peuvent former le premier ressort R1 mentionné dans la première forme de réalisation.

Le bras rigide 213b qui est le plus proche du régulateur 12, peut être relié audit régulateur 12 par un deuxième ressort R2, formé par exemple par une branche élastique formant une succession de créneaux 261. Plus spécialement, cette branche élastique peut être liée à un prolongement rigide 233a du bras 233 du deuxième organe réglant 230.

Comme expliqué dans la première forme de réalisation, l'organe de découplage 213 est agencé pour osciller entre deux positions extrêmes avec la même période d'oscillation que le régulateur, mais avec une amplitude moindre, qui est imposée par des moyens de limitation de mouvement (avantageusement, deux butées entre lesquelles oscille l'organe de découplage et qui limitent la course de l'organe de découplage pour lui imposer de rester immobile sur une partie de la période d'oscillation).

Dans l'exemple de la figure 10, ces moyens de limitation peuvent comprendre par exemple une fente 253 ménagée dans le cadre 215 et dans laquelle est engagée l'extrémité libre de la branche 213b la plus éloignée du régulateur 12. Cette fente 253 est délimitée entre deux faces de butée 253a, 253b qui limitent les mouvements de l'organe de découplage 213, comme expliqué dans la première forme de réalisation.

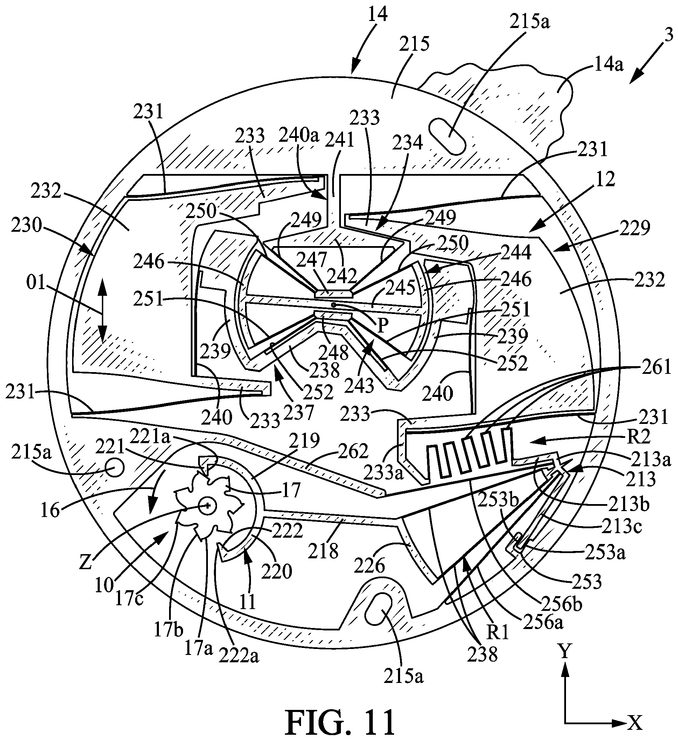

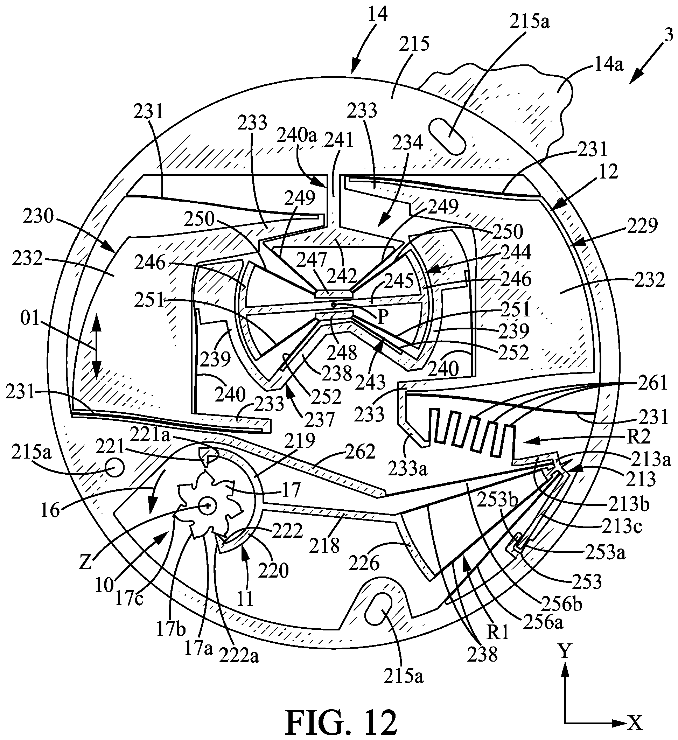

Le fonctionnement du mécanisme dans la deuxième forme de réalisation est similaire à celui déjà décrit dans la première forme de réalisation. Les premier et deuxième organes réglants 229, 230 oscillent selon la direction de translation O1 entre les deux positions extrêmes représentées respectivement sur les figures 11 et 12, avec une fréquence f pouvant être comprise par exemple entre 20 et 30 Hz. Du fait de la limitation de mouvement de l'organe de découplage 213, celui-ci reste immobile contre les butées 253a, 253b pendant un temps d'arrêt total qui est supérieur à 75 % de la période d'oscillation T du régulateur, notamment supérieur à 80 % de T. Le temps d'arrêt total peut être par ailleurs inférieur à 95 % de la période d'oscillation T, notamment inférieur à 90 % de T.

## Revendications

1. Mécanisme pour pièce d'horlogerie (1) comprenant :
- un régulateur (12) comprenant un organe réglant (12a ; 230) adapté pour osciller avec une certaine amplitude nominale et une certaine période d'oscillation,
- un organe de distribution d'énergie (10) pourvu de dents (17 ; 117) et destiné à être sollicité par un dispositif de stockage d'énergie (8),
- une ancre (11) coopérant avec les dents (17 ; 117) de l'organe de distribution d'énergie, ladite ancre étant commandée par le régulateur (12) pour régulièrement et alternativement bloquer et libérer l'organe de distribution d'énergie (10), de sorte que ledit organe de distribution d'énergie (10) se déplace pas à pas sous la sollicitation du dispositif de stockage d'énergie (8) selon un cycle de mouvement répétitif, et ladite ancre (11) étant adaptée pour transférer de l'énergie mécanique au régulateur (12) au cours de ce cycle de mouvement répétitif,
**caractérisé en ce qu'**il comporte :
- un organe de découplage (13 ; 213) relié élastiquement, d'une part à l'ancre (11) par des premiers moyens élastiques de liaison (R1), et d'autre part à l'organe réglant (12a ; 230) par des deuxièmes moyens élastiques de liaison (R2), ledit organe de découplage (13 ; 213) étant agencé pour osciller avec une certaine amplitude entre des première et deuxième positions extrêmes et avec la même période d'oscillation que l'organe réglant (12a ; 230),
- des moyens de limitation de mouvement (52, 54, 55 ; 253a, 253b) pour imposer lesdites positions extrêmes.

2. Mécanisme selon la revendication 1, dans lequel les moyens de limitation de mouvement comprennent deux butées (54, 55 ; 253a, 253b) entre lesquelles oscille l'organe de découplage (13 ; 213).

3. Mécanisme selon la revendication 1 ou la revendication 2, dans lequel l'ancre (11) et l'organe de distribution d'énergie (10) sont conformés pour que, chaque fois que l'organe de distribution d'énergie (10) se déplace, ledit organe de distribution d'énergie donne une impulsion à l'ancre (11) pour transférer de l'énergie mécanique aux premiers moyens élastiques de liaison (R1) juste avant d'être bloqué à nouveau par l'ancre (11).

4. Mécanisme selon l'une quelconque des revendications précédentes, dans lequel l'ancre (11) est montée sur une suspension élastique (27 ; 238, 256a, 256b).

5. Mécanisme selon l'une quelconque des revendications précédentes, dans lequel l'ancre (11) et les premiers moyens élastiques de liaison (R1) sont conçus pour que l'ancre (11) ne libère l'organe de distribution d'énergie (10) que lorsque l'organe de découplage (13) est dans une des première et deuxième positions extrêmes.

6. Mécanisme selon l'une quelconque des revendications précédentes, dans lequel l'organe de distribution d'énergie est une roue d'échappement (10) et l'ancre (11) comporte des premier et deuxième organes d'arrêt (21, 22 ; 121, 122 ; 221, 222) disposés de part et d'autre de la roue d'échappement (10) selon une direction d'échappement, les premier et deuxième organes d'arrêt (21, 22 ; 121, 122 ; 221, 222) étant adaptés pour alternativement bloquer des dents (17) de la roue d'échappement (10), l'ancre (11) étant montée et conformée pour occuper des première et deuxième positions de repos respectivement lorsque les premier et deuxième organes d'arrêt (21, 22; 121, 122 ; 221, 222) bloquent des dents de la roue d'échappement, et pour osciller entre deux extrema d'oscillation situés de part et d'autre des deux positions de repos dans la direction d'échappement.

7. Mécanisme selon la revendication 6, dans lequel l'organe de découplage (13) est mobile dans la direction d'échappement entre lesdites première et deuxième positions extrêmes, les premiers moyens élastiques de liaison (R1) étant conçus pour déplacer l'ancre (11) dans un premier sens (63) dans la direction d'échappement en écartant le premier organe d'arrêt (21 ; 121 ; 221) de la roue d'échappement (10) lorsque l'organe de découplage (13) est au voisinage immédiat de la première position extrême, les premiers moyens élastiques de liaison (R1) étant conçus pour déplacer l'ancre (11) dans un deuxième sens (64) opposé au premier sens (63) dans la direction d'échappement (X) en écartant le deuxième organe d'arrêt (22 ; 122 ; 222) de la roue d'échappement (10) lorsque l'organe de découplage (13) est au voisinage immédiat de la deuxième position extrême, la première position extrême étant décalée dans le premier sens (63) par rapport à la deuxième position extrême.

8. Mécanisme selon l'une quelconque des revendications 6 et 7, dans lequel l'ancre (11) et la roue d'échappement sont conformées pour que, chaque fois que la roue d'échappement (10) se déplace, ladite roue d'échappement donne une impulsion à l'ancre (11) pour transférer de l'énergie mécanique aux premiers moyens élastiques de liaison (R1) juste avant d'être bloquée à nouveau par l'ancre.

9. Mécanisme selon la revendication 8, dans lequel la roue d'échappement (10) est conçue pour tourner dans un unique sens de rotation (16) et chaque dent (17) de la roue d'échappement comporte un bord avant convexe (17a), orienté dans le sens de rotation (16), qui est adapté pour agir par effet de came sur soit le premier organe d'arrêt (21), soit le deuxième organe d'arrêt (22) pour donner ladite impulsion à l'ancre (11), ledit bord avant convexe (17a) s'étendant, dans un sens angulaire opposé à la direction de rotation (16), jusqu'à un bord d'arrêt (17c) adapté pour venir buter contre soit le premier organe d'arrêt (21), soit le deuxième organe d'arrêt (22) pour bloquer la roue d'échappement (10).

10. Mécanisme selon l'une quelconque des revendications 8 et 9 en combinaison avec la revendication 7, dans lequel la roue d'échappement (10) et l'ancre (11) sont conçues pour qu'à la fin de chaque impulsion, les premiers moyens élastiques de liaison (R1) soient dans un état de déformation élastique imposé géométriquement, soit par la première position de repos de l'ancre et la deuxième position extrême de l'organe de découplage, soit par la deuxième position de repos de l'ancre et la première position extrême de l'organe de découplage.

11. Mécanisme selon l'une quelconque des revendications précédentes, dans lequel l'amplitude de l'organe de découplage (13) est inférieure à l'amplitude nominale d'oscillation de l'organe réglant (12a), en particulier inférieure à 25 % de l'amplitude nominale d'oscillation de l'organe réglant (12a), notamment inférieure à 20 % de l'amplitude nominale d'oscillation de l'organe réglant (12a).

12. Mécanisme selon l'une quelconque des revendications précédentes, dans lequel l'amplitude de l'organe de découplage (13 ; 213) est supérieure à 5 % de l'amplitude nominale d'oscillation de l'organe réglant (12a ; 230), notamment supérieure à 10 % de l'amplitude nominale d'oscillation de l'organe réglant (12a ; 230).

13. Mécanisme selon l'une quelconque des revendications précédentes, dans lequel les moyens de limitation de mouvement (52, 54, 55 ; 253a, 253b) sont adaptés pour imposer à l'organe de découplage (13 ; 213) de rester immobile pendant un certain temps d'arrêt dans chacune des positions extrêmes, l'organe de découplage (13 ; 213) étant immobilisé lors de chaque période d'oscillation, pendant un certain temps d'arrêt total qui est supérieur à 75 % de la période d'oscillation, notamment supérieur à 80 % de la période d'oscillation.

14. Mécanisme selon la revendication 13, dans lequel le temps d'arrêt total est inférieur à 95 % de la période d'oscillation, notamment inférieur à 90 % de la période d'oscillation.

15. Mécanisme selon l'une quelconque des revendications précédentes, dans lequel l'organe de découplage (13 ; 213) est rigide.

16. Mécanisme selon l'une quelconque des revendications précédentes, dans lequel le régulateur (12), l'ancre (11) et l'organe de découplage (13 ; 213) constituent un système monolithique formé dans une même plaque (14) et sont conçus pour se déplacer essentiellement dans un plan moyen de ladite plaque.

17. Mécanisme selon l'une quelconque des revendications précédentes, dans lequel l'organe de découplage (13 ; 213) est guidé par une suspension élastique (56 ; 256a, 256b) qui relie ledit organe de découplage (13 ; 213) à un support fixe (15).

18. Pièce d'horlogerie comprenant un mécanisme selon l'une quelconque des revendications précédentes.

## Patentansprüche

1. Mechanismus für eine Uhr (1), aufweisend:
- einen Regulator (12) mit einem regelnden Element (12a; 230), das eingerichtet ist, mit einer gewissen nominalen Amplitude und einer gewissen Oszillationsperiode zu oszillieren,
- ein Energieverteilungselement (10), das mit Zähnen (17; 117) versehen ist und konfiguriert ist, von einer Energiespeichervorrichtung (8) belastet zu werden,
- einen Anker (11), der mit den Zähnen (17; 117) des Energieverteilungselements zusammenwirkt, wobei der Anker von dem Regulator (12) gesteuert wird, um das Energieverteilungselement (10) regelmäßig und abwechselnd zu blockieren und freizugeben, so dass das Energieverteilungselement (10) Schritt für Schritt unter der Belastung der Energiespeichervorrichtung (8) gemäß einem sich wiederholenden Bewegungszyklus sich verschiebt, und wobei der Anker (11) eingerichtet ist, im Verlaufe dieses sich wiederholenden Bewegungszyklus mechanische Energie auf den Regulator (12) zu übertragen,
**dadurch gekennzeichnet, dass** er aufweist:
- ein Entkopplungselement (13; 213), das einerseits über erste elastische Verbindungseinrichtungen (R1) mit dem Anker (11) und andererseits über zweite elastische Verbindungseinrichtungen (R2) mit dem regelnden Element (12a; 230) elastisch verbunden ist, wobei das Entkopplungselement (13; 213) konfiguriert ist, mit einer gewissen Amplitude zwischen einer ersten und zweiten Extremposition und mit der gleichen Oszillationsperiode wie das regelnde Element (12a; 230) zu oszillieren,
- Bewegungsbegrenzungseinrichtungen (52, 54, 55; 253a, 253b) zum Auferlegen der Extrempositionen.

2. Mechanismus nach Anspruch 1, in welchem die Bewegungsbegrenzungseinrichtungen zwei Anschläge (54, 55; 253a, 253b) aufweisen, zwischen denen das Entkopplungselement (13; 213) oszilliert.

3. Mechanismus nach Anspruch 1 oder Anspruch 2, in welchem der Anker (11) und das Energieverteilungselement (10) so konfiguriert sind, dass jedes Mal, wenn das Energieverteilungselement (10) sich verschiebt, das Energieverteilungselement dem Anker (11) einen Impuls gibt, um mechanische Energie auf die ersten elastischen Verbindungseinrichtungen (R1) zu übertragen, unmittelbar bevor es erneut von dem Anker (11) blockiert wird.

4. Mechanismus nach einem der vorstehenden Ansprüche, in welchem der Anker (11) an einer elastischen Aufhängung (27; 238, 256a, 256b) angebracht ist.

5. Mechanismus nach einem der vorstehenden Ansprüche, in welchem der Anker (11) und die ersten elastischen Verbindungseinrichtungen (R1) so konfiguriert sind, dass der Anker (11) das Energieverteilungselement (10) nur dann freigibt, wenn das Entkopplungselement (13) in der ersten oder der zweiten Extremposition ist.

6. Mechanismus nach einem der vorstehenden Ansprüche, in welchem das Energieverteilungselement ein Hemmungsrad (10) ist und der Anker (11) erste und zweite Sperrelemente (21, 22; 121, 122; 221, 222) aufweist, die entlang einer Hemmungsrichtung beiderseits des Hemmungsrads (10) angeordnet sind, wobei die ersten und zweiten Sperrelemente (21, 22; 121, 122; 221, 222) eingerichtet sind, Zähne (17) des Hemmungsrads (10) abwechselnd zu blockieren, wobei der Anker (11) angebracht und gestaltet ist, um eine erste bzw. zweite Ruheposition einzunehmen, wenn die ersten und zweiten Sperrelemente (21, 22; 121, 122; 221, 222) Zähne des Hemmungsrads blockieren, und um zwischen zwei Oszillationsextremen zu oszillieren, die sich entlang der Hemmungsrichtung beiderseits der zwei Ruhepositionen befinden.

7. Mechanismus nach Anspruch 6, in welchem das Entkopplungselement (13) in der Hemmungsrichtung zwischen der ersten und zweiten Extremposition beweglich ist, wobei die ersten elastischen Verbindungseinrichtungen (R1) konfiguriert sind, durch Wegrücken des ersten Sperrelements (21; 121; 221) von dem Hemmungsrad (10) den Anker (11) in der Hemmungsrichtung zu einer ersten Seite (63) hin zu verschieben, wenn das Entkopplungselement (13) in unmittelbarer Nähe der ersten Extremposition ist, wobei die ersten elastischen Verbindungseinrichtungen (R1) konfiguriert sind, durch Wegrücken des zweiten Sperrelements (22; 122; 222) von dem Hemmungsrad (10) den Anker (11) in der Hemmungsrichtung (X) zu einer zweiten Seite (64) hin, die entgegengesetzt zur ersten Seite (63) ist, zu verschieben, wenn das Entkopplungselement (13) in unmittelbarer Nähe der zweiten Extremposition ist, wobei die erste Extremposition bezüglich der zweiten Extremposition zur ersten Seite (63) hin versetzt ist.

8. Mechanismus nach einem der Ansprüche 6 und 7, in welchem der Anker (11) und das Hemmungsrad konfiguriert sind, dass jedes Mal, wenn das Hemmungsrad (10) sich verschiebt, das Hemmungsrad dem Anker (11) einen Impuls gibt, um mechanische Energie auf die ersten elastischen Verbindungseinrichtungen (R1) zu übertragen, unmittelbar bevor es erneut von dem Anker blockiert wird.

9. Mechanismus nach Anspruch 8, in welchem das Hemmungsrad (10) konfiguriert ist, sich in einer einzigen Drehrichtung (16) zu drehen, und jeder Zahn (17) des Hemmungsrads eine in die Drehrichtung (16) orientierte konvexe Vorderkante (17a) aufweist, die eingerichtet ist, mittels Nockeneffekt entweder auf das erste Sperrelement (21) oder das zweite Sperrelement (22) zu wirken, um dem Anker (11) den Impuls zu geben, wobei die konvexe Vorderkante (17a) sich in einer zur Drehrichtung (16) entgegengesetzten Winkelrichtung bis zu einer Sperrkante (17c) erstreckt, die eingerichtet ist, entweder gegen das erste Sperrelement (21) oder das zweite Sperrelement (22) in Anschlag zu kommen, um das Hemmungsrad (10) zu blockieren.

10. Mechanismus nach einem der Ansprüche 8 und 9 in Kombination mit Anspruch 7, in welchem das Hemmungsrad (10) und der Anker (11) konfiguriert sind, dass am Ende jedes Impulses die ersten elastischen Verbindungseinrichtungen (R1) in einem entweder von der ersten Ruheposition des Ankers und der zweiten Extremposition des Entkopplungselements oder von der zweiten Ruheposition des Ankers und der ersten Extremposition des Entkopplungselements geometrisch auferlegten elastischen Verformungszustand sind.

11. Mechanismus nach einem der vorstehenden Ansprüche, in welchem die Amplitude des Entkopplungselements (13) kleiner als die nominale Oszillationsamplitude des regelnden Elements (12a) ist, speziell kleiner als 25% der nominalen Oszillationsamplitude des regelnden Elements (12a), insbesondere kleiner als 20% der nominalen Oszillationsamplitude des regelnden Elements (12a).

12. Mechanismus nach einem der vorstehenden Ansprüche, in welchem die Amplitude des Entkopplungselements (13; 213) größer als 5% der nominalen Oszillationsamplitude des regelnden Elements (12a; 230) ist, insbesondere größer als 10% der nominalen Oszillationsamplitude des regelnden Elements (12a; 230).

13. Mechanismus nach einem der vorstehenden Ansprüche, in welchem die Bewegungsbegrenzungseinrichtungen (52, 54, 55; 253a, 253b) eingerichtet sind, das Entkopplungselement (13; 213) zu zwingen, in jeder der Extrempositionen während einer gewissen Sperrzeit immobil zu bleiben, wobei das Entkopplungselement (13; 213) bei jeder Oszillationsperiode während einer gewissen Gesamtsperrzeit immobilisiert wird, die größer als 75% der Oszillationsperiode ist, insbesondere größer als 80% der Oszillationsperiode.

14. Mechanismus nach Anspruch 13, in welchem die Gesamtsperrzeit kleiner als 95% der Oszillationsperiode ist, insbesondere kleiner als 90% der Oszillationsperiode.

15. Mechanismus nach einem der vorstehenden Ansprüche, in welchem das Entkopplungselement (13; 213) starr ist.

16. Mechanismus nach einem der vorstehenden Ansprüche, in welchem der Regulator (12), der Anker (11) und das Entkopplungselement (13; 213) ein in einer einzigen Platte (14) gebildetes monolithisches System bilden und konfiguriert sind, sich im Wesentlichen in einer Mittelebene der Platte zu verschieben.

17. Mechanismus nach einem der vorstehenden Ansprüche, in welchem das Entkopplungselement (13; 213) von einer elastischen Aufhängung (56; 256a; 256b) geführt wird, die das Entkopplungselement (13; 213) mit einem stationären Träger (15) verbindet.

18. Uhr mit einem Mechanismus nach einem der vorstehenden Ansprüche.

## Claims

1. Mechanism for a timepiece (1) comprising:
- a regulator (12) comprising a regulating member (12a; 230) adapted to oscillate with a certain nominal amplitude and a certain period of oscillation,
- an energy distributing member (10) provided with teeth (17; 117) and intended to be biased by an energy storage device (8),
- a pallet fork (11) engaging with the teeth (17; 117) of the energy distributing member, said pallet fork being controlled by the regulator (12) to periodically and alternately lock and release the energy distributing member (10) so that said energy distributing member (10) is biased by the energy storage device (8) to move in incremental steps in a cycle of repetitive motion, and said pallet fork (11) being adapted to transfer mechanical energy to the regulator (12) during this cycle of repetitive motion,
**characterized in that** it comprises:
- a decoupling member (13; 213) elastically connected to the pallet fork (11) by first elastic linking means (R1) and to the regulating member (12a; 230) by second elastic linking means (R2), said decoupling member (13; 213) being arranged to oscillate with a certain amplitude between first and second extreme positions and with the same period of oscillation as the regulating member (12a; 230),
- motion limiting means (52, 54, 55; 253a, 253b) for imposing said extreme positions.

2. Mechanism according to claim 1, wherein the motion limiting means comprise two stop elements (54, 55; 253a, 253b) between which the decoupling member (13; 213) oscillates.

3. Mechanism according to claim 1 or claim 2, wherein the pallet fork (11) and the energy distributing member (10) are shaped so that, whenever the energy distributing member (10) moves, said energy distributing member supplies an impulse to the pallet fork (11) in order to transfer mechanical energy to the first elastic linking means (R1) just before being relocked by the pallet fork (11).

4. Mechanism according to any preceding claim, wherein the pallet fork (11) is mounted on an elastic suspension (27; 238, 256a, 256b).

5. Mechanism according to any preceding claim, wherein the pallet fork (11) and the first elastic linking means (R1) are designed so that the pallet fork (11) only releases the energy distributing member (10) when the decoupling member (13) is in one of the first and second extreme positions.

6. Mechanism according to any preceding claim, wherein the energy distributing member is an escape wheel (10) and the pallet fork (11) comprises first and second stop members (21, 22; 121, 122; 221, 222) arranged one on each side of the escape wheel (10) along an escape direction, the first and second stop members (21, 22; 121, 122; 221, 222) being adapted to alternate in locking the teeth (17) of the escape wheel (10), the pallet fork (11) being mounted and shaped so as to occupy first and second rest positions respectively when the first and second stop members (21, 22; 121, 122; 221, 222) lock the teeth of the escape wheel, and to oscillate between two extreme oscillation positions located one on each side of the two rest positions along the escape direction.

7. Mechanism according to claim 6, wherein the decoupling member (13) is movable along the escape direction between said first and second extreme positions, the first elastic linking means (R1) being designed to move the pallet fork (11) in a first direction (63) along the escape direction by distancing the first stop member (21; 121; 221) from the escape wheel (10) when the decoupling member (13) is in the immediate vicinity of the first extreme position, the first elastic linking means (R1) being designed to move the pallet fork (11) in a second direction (64) opposite to the first direction (63) along the escape direction (X) by distancing the second stop member (22; 122; 222) from the escape wheel (10) when the decoupling member (13) is in the immediate vicinity of the second extreme position, the first extreme position being offset along the first direction (63) relative to the second extreme position.

8. Mechanism according to any one of claims 6 and 7, wherein the pallet fork (11) and the escape wheel are shaped such that, whenever the escape wheel (10) moves, said escape wheel supplies an impulse to the pallet fork (11) in order to transfer mechanical energy to the first elastic linking means (R1) just before being relocked by the pallet fork.

9. Mechanism according to claim 8, wherein the escape wheel (10) is designed to rotate in a single direction of rotation (16) and each tooth (17) of the escape wheel has a convex front edge (17a), oriented in the direction of rotation (16), which is adapted to act as a cam on either the first stop member (21) or the second stop member (22) in order to supply said impulse to the pallet fork (11), said convex front edge (17a) extending in an angular direction that is opposite to the direction of rotation (16), to a stop edge (17c) adapted to abut against either the first stop member (21) or the second stop member (22) in order to lock the escape wheel (10).

10. Mechanism according to either of claims 8 and 9 in combination with claim 7, wherein the escape wheel (10) and the pallet fork (11) are designed so that at the end of each impulse, the first elastic linking means (R1) are in a state of elastic deformation dictated geometrically either by the first rest position of the pallet fork and the second extreme position of the decoupling member or by the second rest position of the pallet fork and the first extreme position of the decoupling member.

11. Mechanism according to any preceding claim, wherein the amplitude of the decoupling member (13) is less than the nominal oscillation amplitude of the regulating member (12a), in particular less than 25% of the nominal oscillation amplitude of the regulating member (12a), more particularly less than 20% of the nominal oscillation amplitude of the regulating member (12a).

12. Mechanism according to any preceding claim, wherein the amplitude of the decoupling member (13; 213) is greater than 5% of the nominal oscillation amplitude of the regulating member (12a; 230), in particular greater than 10% of the nominal oscillation amplitude of the regulating member (12a; 230) .

13. Mechanism according to any preceding claim, wherein the motion limiting means (52, 54, 55; 253a, 253b) are adapted to keep the decoupling member (13; 213) motionless for a certain stop time at each of the extreme positions, the decoupling member (13; 213) being immobilized during each period of oscillation for a total stop time which is greater than 75% of the period of oscillation, in particular greater than 80% of the period of oscillation.

14. Mechanism according to claim 13, wherein the total stop time is less than 95% of the period of oscillation, in particular less than 90% of the period of oscillation.

15. Mechanism according to any preceding claim, wherein the decoupling member (13; 213) is rigid.

16. Mechanism according to any preceding claim, wherein the regulator (12), the pallet fork (11), and the decoupling member (13; 213) constitute an integral one-piece system formed in a same plate (14) and are designed to move substantially within a central plane of said plate.

17. Mechanism according to any preceding claim, wherein the decoupling member (13; 213) is guided by an elastic suspension (56; 256a, 256b) connecting said decoupling member (13; 213) to a fixed support (15).

18. Timepiece comprising a mechanism as claimed in any preceding claim.
